(19) Europäisches Patentamt
European Patent Office
Office européen des brevets

(11) **EP 2 818 316 B1**

(12) **EUROPEAN PATENT SPECIFICATION**

(45) Date of publication and mention
of the grant of the patent:
**13.09.2023 Bulletin 2023/37**

(21) Application number: **13751356.0**

(22) Date of filing: **20.02.2013**

(51) International Patent Classification (IPC):
**B32B 27/30** (2006.01)  **B32B 15/082** (2006.01)
**B65D 65/40** (2006.01)  **F16L 59/06** (2006.01)
**C23C 14/20** (2006.01)

(52) Cooperative Patent Classification (CPC):
**B32B 27/306; B32B 15/082; B32B 27/32;
C23C 14/022; C23C 14/20; C23C 14/541;**
B32B 2255/10; B32B 2255/20; B32B 2255/205

(86) International application number:
**PCT/JP2013/054138**

(87) International publication number:
**WO 2013/125564 (29.08.2013 Gazette 2013/35)**

(54) **POLYVINYL ALCOHOL VAPOR-DEPOSITED FILM**

**DURCH DAMPFABSCHEIDUNG ENTSTANDENER POLYVINYLALKOHOLFILM**

**FILM ÉVAPORÉ À BASE D'ALCOOL POLYVINYLIQUE**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.02.2012 JP 2012034073**

(43) Date of publication of application:
**31.12.2014 Bulletin 2015/01**

(73) Proprietor: **Kuraray Co., Ltd.
Okayama 710-0801 (JP)**

(72) Inventors:
• **NONAKA Yasuhiro
Kurashiki-shi
Okayama 713-8550 (JP)**
• **KAWAI Hiroshi
Kurashiki-shi
Okayama 713-8550 (JP)**
• **YAMAKOSHI Satoshi
Kurashiki-shi
Okayama 713-8550 (JP)**

(74) Representative: **Müller-Boré & Partner
Patentanwälte PartG mbB
Friedenheimer Brücke 21
80639 München (DE)**

(56) References cited:
**WO-A1-2008/044549     JP-A- H10 122 477
JP-A- S59 106 958       JP-A- S61 281 147
JP-A- 2006 266 348      JP-A- 2007 290 144
JP-B2- 3 675 904        JP-B2- S6 325 615
US-A- 5 175 054         US-A1- 2009 110 888
US-A1- 2009 130 778**

• **JAMES M. BURKSTRAND: "Metal-polymer
interfaces: Adhesion and x-ray photoemission
studies", JOURNAL OF APPLIED PHYSICS, vol.
52, no. 7, 1 July 1981 (1981-07-01), page 4795,
XP055218109, ISSN: 0021-8979, DOI:
10.1063/1.329320**

**Description**

[TECHNICAL FIELD]

The present invention relates to a vapor-deposited polyvinyl alcohol film.

[BACKGROUND ART]

Hitherto, thermal insulators produced using polyurethane foams have been used as thermal insulation materials for refrigerators, thermal insulation panels for thermal insulation walls of houses, thermal insulation materials for hot water storage tanks, and the like. As a more superior material that replaces the thermal insulators produced using polyurethane foams, vacuum thermal insulators constituted with a laminate film that exhibits a gas barrier property even under high humidity and a core material have come into use. In this case, aluminum foils are largely used as a gas barrier material; however, since aluminum is a good thermal conductor, there has been pointed out a drawback that a significant amount of heat passes through an aluminum portion in the film, resulting in impairment of the thermal insulation performances of the vacuum thermal insulators. In order to eliminate this drawback, superior gas barrier films such as silica vapor-deposited films, and polyester films or ethylene-vinyl alcohol copolymer (hereinafter, may be abbreviated as EVOH) films having a thin aluminum vapor-deposited layer in place of the aluminum foil have been investigated.

However, the thickness of these vapor-deposited layers is as small as tens of nanometers; therefore, these vapor-deposited layers have a disadvantage that deterioration of the gas barrier property is caused by flexure of the films in production processes of laminate films and/or in production processes of vacuum thermal insulators. As a solution to this disadvantage, a technique for improving pinhole resistance by incorporating a filler into a gas barrier resin is known (see Japanese Unexamined Patent Application, Publication No. 2002-310385). Moreover, a technique for allowing a barrier property to be stably exhibited by a surface treatment of a substrate film has also been investigated (see Japanese Unexamined Patent Application, Publication No. 2005-290108).

[PRIOR ART DOCUMENTS]

[PATENT DOCUMENTS]

Patent Document 1: Japanese Unexamined Patent Application, Publication No. 2002-310385

Patent Document 2: Japanese Unexamined Patent Application, Publication No. 2005-290108

[SUMMARY OF THE INVENTION]

[PROBLEMS TO BE SOLVED BY THE INVENTION]

However, even when such techniques are employed, a pinhole and/or a crack is formed in the vapor-deposited layer due to the flexure, leading to deterioration of the gas barrier property; thus, an improvement of the flex resistance of the vapor-deposited layer in a processing such as lamination has been desired.

The present invention, a vapor-deposited film and a method for producing this vapor-deposited film, are claimed in independent claims 1 and 9. Further embodiments are set forth in dependent claims 2-8 and 10.

[EFFECTS OF THE INVENTION]

The vapor-deposited film according to the aspect of the present invention enables the formation of a pinhole and/or a crack in a processing of the vapor-deposited film such as lamination to be suppressed, and the deterioration of the gas barrier property thereof to be inhibited. Therefore, the vapor-deposited film can be preferably used as packaging materials and materials for vacuum thermal insulators.

[BRIEF DESCRIPTION OF THE DRAWINGS]

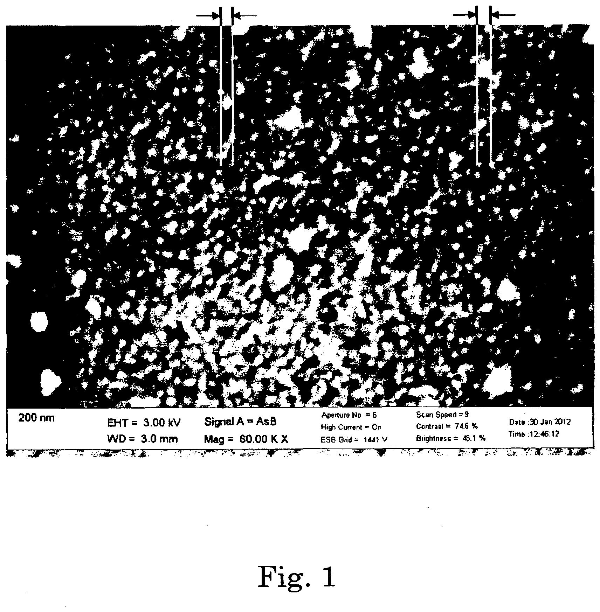

Fig. 1 illustrates a scanning electron micrograph of a vapor-deposited film obtained in Example 2, in which the width of the Figure corresponds to a length of 1.94 $\mu$m.

[DESCRIPTION OF EMBODIMENTS]

Substrate Film

The polyvinyl alcohol polymer contained in the substrate film can be obtained by saponifying a vinyl ester homopolymer, or a copolymer of a vinyl ester in an amount of 40 mol% or more with other monomer(s) using an alkali catalyst or the like. The vinyl ester is typified by vinyl acetate, but other fatty acid vinyl ester such as vinyl propionate or vinyl pivalate may be also used. In addition, the polyvinyl alcohol polymer may be a copolymer of a vinyl ester with one or more types of other monomers exemplified by: ethylene; $\alpha$-olefins such as propylene, butylene, isobutene, 4-methyl-1-pentene, 1-hexene and 1-octene; unsaturated carboxylic acids or esters thereof such as (meth)acrylic acid; vinylsilane compounds such as vinyltrimethoxysilane; unsaturated sulfonic acids or salts thereof; and vinylpyrrolidone compounds such as N-vinylpyrrolidone, within a range not leading to inhibition of the effects of the present invention. Among these, the monomer to be copolymerized is preferably ethylene in light of the ease of melt molding of the resultant polyvinyl alcohol polymer. In a case where the other monomer is ethylene, the percentage content of the ethylene unit with respect to the total units constituting the polyvinyl alcohol polymer is 3 mol% to 60 mol%, preferably 10 mol% to 60 mol%, and more preferably 20 mol% to 55 moll.

The polyvinyl alcohol polymer contained in the substrate film may be produced by well-known methods. A chain transfer agent may be used in the production, and examples of the chain transfer agent include alkylthiols, and the like.

Moreover, the degree of saponification of the polyvinyl alcohol polymer (proportion (mol%) of vinyl alcohol units with respect to the total of the vinyl alcohol units and the vinyl ester units) is 99 mol% or more. When the degree of saponification is less than 90 mol%, the gas barrier property of the vapor-deposited film under high humidity may be deteriorated. In a case where the polyvinyl alcohol polymer contains two or more types of polyvinyl alcohol polymer components having a different degree of saponification, an average calculated based on a mass ratio of each polyvinyl alcohol polymer component contained is designated as the degree of saponification of the polyvinyl alcohol polymer. The degree of saponification of the polyvinyl alcohol polymer can be determined by nuclear magnetic resonance (NMR) spectroscopy.

The oxygen permeability coefficient of the substrate film determined at 20 °C-65% RH is preferably 50 mL·20 $\mu$m/m$^2$·day·atm or less, more preferably 10 mL·20 $\mu$m/m$^2$·day·atm or less, still more preferably 5 mL·20 $\mu$m/m$^2$·day·atm or less, and particularly preferably 1 mL·20 $\mu$m/m$^2$·day·atm or less. When the oxygen permeability coefficient is less than the above upper limit, the thickness of a barrier film can be reduced in producing a vacuum thermal insulator using the substrate film, leading to a cost reduction.

As referred to herein, "20 °C-65% RH" means 65% relative humidity at 20 °C, and "50 mL·20 $\mu$m/m$^2$·day·atm" means that 50 mL per day of an oxygen gas transmits through 1 m$^2$ of a film under a pressure difference of an oxygen gas of 1 atm with a proviso that the film has a thickness of 20 $\mu$m.

The average thickness of the substrate film is not particularly limited, but is preferably 30 $\mu$m or less, more preferably 25 um or less, and still more preferably 20 $\mu$m or less. Moreover, the average thickness is preferably 5 $\mu$m or more, more preferably 7 um or more, and still more preferably 10 $\mu$m or more.

The method for production of the substrate film is not particularly limited, and examples thereof include a casting process, accompanied or unaccompanied by stretching. Any of a biaxially stretching method, a uniaxially stretching method and an inflation method may be employed as a method for stretching the film.

The process of the stretching is not particularly limited, and either of a simultaneous stretching process or a sequential stretching process may be employed. The stretching ratio in terms of area ratio is preferably 12-fold or less, and more preferably 11-fold or less. Moreover, the stretching ratio in terms of area ratio is preferably 8-fold or more, and more preferably 9-fold or more. The area ratio of 8 to 12-fold is preferred in light of uniformity of the thickness, a gas barrier property and mechanical strength of the resultant film. When the area ratio is less than 8-fold, unevenness of stretching may be likely to be left, whereas when the area ratio is greater than 12-fold, the film may be likely to be broken during the stretching.

Moreover, continuous stretching is facilitated by beforehand hydrating a raw film before the stretching. The moisture content of the raw film before the stretching is preferably 2% by mass or more, more preferably 5% by mass or more, and still more preferably 10% by mass or more. The moisture content of the raw film before the stretching is preferably 30% by mass or less, more preferably 25% by mass or less, and still more preferably 20% by mass or less. When the moisture content is less than 2% by mass, unevenness of stretching may be likely to be left, and in particular in stretching using a tenter, a breakage may be likely to occur in the vicinity of a grip due to a high stretching ratio in the vicinity of the grip. On the other hand, when the moisture content is greater than 30% by mass, the modulus of elasticity of the stretched portions may be low, leading to an insufficient difference of the modulus of elasticity between at the stretched portions and at unstretched portions, and as a result, unevenness of stretching may be likely to be left.

Although the temperature for stretching may be somewhat varied in accordance with the moisture content of the raw film before the stretching, a temperature range of 50 °C to 130 °C is typically used. In particular, in a simultaneous biaxial stretching, a biaxially stretched film with a reduced thickness variation may be likely to be obtained in a temperature range of 70 °C to 100 °C, whereas in a sequential biaxial stretching, a biaxially stretched film with a reduced thickness variation may be likely to be obtained in a temperature range of 70 °C to 100 °C for stretching along a longitudinal direction using a roller, and in a temperature range of 80 °C to 120 °C for stretching along a width direction using a tenter.

The polyvinyl alcohol polymer may contain an inorganic oxide. Although the inorganic oxide is not particularly limited, examples thereof include silicon oxide, aluminum oxide, magnesium oxide, zirconium oxide, cerium oxides, tungsten oxides, molybdenum oxides, a complex thereof and the like. Among these inorganic oxides, silicon oxide and silicon oxide-magnesium oxide are preferred, and silicon oxide is more preferred.

The percentage content of the inorganic oxide with respect to 100% by mass of the polyvinyl alcohol polymer is preferably 0.001% by mass or more, more preferably 0.005% by mass or more, and still more preferably 0.01% by mass or more. In addition, the percentage content of the inorganic oxide is preferably 1% by mass or less, more preferably 0.75% by mass or less, and still more preferably 0.5% by mass or less. When the percentage content of the inorganic oxide is greater than 1% by mass, gels, fish eyes and the like may be likely to be formed, and the gas barrier property may be deteriorated due to vapor deposition voids or the like.

The mean particle diameter of the inorganic oxide as determined by laser diffraction is preferably 2 um or more, and more preferably 2.5 $\mu$m or more. Moreover, the mean particle diameter of the oxide is preferably 10 um or less, more preferably 5 $\mu$m or less, and still more preferably 3.5 $\mu$m or less. When the mean particle diameter of the inorganic oxide is greater than 10 um, gels, fish eyes and the like may be likely to be formed. On the other hand, when the mean particle diameter of the inorganic oxide is less than 2 $\mu$m, the gas barrier property may be deteriorated. The method for incorporating the inorganic oxide is not particularly limited, and examples thereof include: a method in which the inorganic oxide is added as an aqueous dispersion liquid in the production of the polyvinyl alcohol polymer, followed by deposition in a coagulation bath and drying; a method in which melt kneading is carried out using an extruder or the like; a dry blending method; a method in which a master batch is admixed; and the like.

Moreover, an antioxidant, a plasticizer, a heat stabilizer, a UV absorbent, an antistatic agent, a colorant, a filler or the like may be blended into the polyvinyl alcohol polymer within a range not leading to inhibition of the effects of the present invention.

Metal Vapor-Deposited Layer

The metal vapor-deposited film according to the embodiment of the present invention includes a metal vapor-deposited layer provided on the substrate film that contains the polyvinyl alcohol polymer. The metal to be vapor-deposited is preferably aluminum in light of its advantages such as lightness, flexibility and glossiness. The mean particle size in the metal vapor-deposited layer is 150 nm or less, preferably 125 nm or less, more preferably 100 nm or less, still more preferably 75 nm or less, and particularly preferably 50 nm or less. Moreover, although the lower limit of the mean particle size in the metal vapor-deposited layer is not particularly limited, the mean particle size is preferably 10 nm or more, more preferably 15 nm or more, and still more preferably 20 nm or more. The particle size in the metal vapor-deposited layer is determined using an electron microscope such as a scanning electron microscope; in a case where the metal vapor-deposited layer is formed of metal particles, the particle size in the metal vapor-deposited layer means the particle diameter of the metal particles, whereas in a case where the metal vapor-deposited layer is formed of metal agglomerates, the particle size in the metal vapor-deposited layer means the particle diameter of metal particles that constitute the agglomerates. In addition, the mean particle size in the metal vapor-deposited layer means a number-average of the maximum length along a single direction of the respective metal particles or the like found using an electron microscope.

The average thickness of the metal vapor-deposited layer is preferably 100 nm or less, more preferably 90 nm or less, and still more preferably 80 nm or less. Moreover, the average thickness of the metal vapor-deposited layer is preferably 15 nm or more, more preferably 20 nm or more, and still more preferably 30 nm or more. When the average thickness is greater than 100 nm, a thermal bridge may be likely to be formed in a vacuum thermal insulator, and the thermal insulation effect may be impaired. When the average thickness is less than 15 nm, the gas barrier property may be insufficient. It is to be noted that the average thickness of the metal vapor-deposited layer as referred to means an average of the thicknesses of the metal vapor-deposited layer as determined using an electron microscope at arbitrary 10 points in the cross section of the metal vapor-deposited layer.

The method for attaining the mean particle size in the metal vapor-deposited layer of 150 nm or less may be exemplified by: a method in which in the production of the vapor-deposited film, the volatile matter content in a substrate film used for vapor deposition is adjusted to be 1.1% by mass or less; a method in which the surface temperature of a substrate film in vapor deposition is adjusted to be 60 °C or less; a method in which the surface of a substrate film before vapor deposition is plasma treated and thereby modified; or the like. The volatile matter content contained in the substrate film used for vapor deposition is 1.1% by mass or less, more preferably 0.5% by mass or less, and still more preferably 0.3% by mass or less. Moreover, although the lower limit of the volatile matter content is not particularly limited, the volatile matter content is preferably 0.01% by mass or more, more preferably 0.03% by mass or more, and still more preferably 0.05% by mass or more. It is to be noted that the volatile matter content can be determined from a change of the mass of the substrate film between before and after drying at 105 °C according to the following equation:

$$\text{volatile matter content (\% by mass)} = [(\text{mass before drying} - \text{mass after drying})/ \text{mass after drying}] \times 100$$

The surface temperature of the substrate film in the metal vapor deposition is 60 °C or less, more preferably 55 °C or less, and still more preferably 50 °C or less. Moreover, although the lower limit of the surface temperature of the substrate film in the vapor deposition is not particularly limited, the surface temperature of the substrate film in the vapor deposition is preferably 0 °C or more, more preferably 10 °C or more, and still more preferably 20 °C or more.

Although well-known plasma treatment methods may be used as the method for plasma treating the surface of the substrate film before the vapor deposition, an atmospheric-pressure plasma treatment is preferred, among others. In the atmospheric-pressure plasma treatment, a nitrogen gas, a helium gas, a neon gas, an argon gas, a krypton gas, a xenon gas, a radon gas or the like is used as a discharge gas. Among these, a nitrogen gas, a helium gas and an argon gas are preferably used, and a nitrogen gas is particularly preferably used in light of achievement of a cost reduction.

The vapor-deposited film according to the embodiment of the present invention may further include a resin coating layer that contains a polyvinyl alcohol polymer and that is provided on the metal vapor-deposited layer. When the vapor-deposited film further includes the resin coating layer, deterioration of the gas barrier property of the vapor-deposited film caused by the flexure thereof, which may occur in the production of the vapor-deposited film, e.g., in film processing such as lamination which may be subsequently conducted, can be further inhibited. As a material for the resin coating layer, a water soluble or water dispersible polymer, i.e., a polymer that can be completely dissolved or finely dispersed in a solvent that contains water as a principal component at a normal temperature is preferred. Although such a polymer is not particularly limited, examples thereof include polymers exhibiting water solubility, water dispersibility or the like among the polymers exemplified as the polyvinyl alcohol polymer that can be used in the substrate film.

A swelling inorganic layered silicate may be dispersed in the resin coating layer. Although the percentage content of the swelling inorganic layered silicate with respect to the polyvinyl alcohol polymer in the resin coating layer is not particularly limited, the percentage content of the swelling inorganic layered silicate is preferably 0.5% by mass to 55% by mass in terms of solid content equivalent. When the percentage content of the swelling inorganic layered silicate is greater than 55% by mass, the flexibility of the resin coating layer is likely to be deteriorated and thus defects such as cracks are likely to be formed. The percentage content of the swelling inorganic layered silicate is more preferably 1% by mass to 40% by mass, still more preferably 3% by mass to 30% by mass, and particularly preferably 5% by mass to 20% by mass.

Although the method for providing the resin coating layer on the metal vapor-deposited layer is not particularly limited, a preferable method is exemplified by: a coating method in which a coating liquid of a resin composition is applied onto the surface of the metal vapor-deposited layer, followed by drying and a heat-treatment; and a method in which a resin coating layer is laminated on the metal vapor-deposited layer side. In addition, an interface between the metal vapor-deposited layer and the resin coating layer may have undergone a corona treatment or a treatment with an anchor coating agent or the like. Examples of the coating method include: a direct gravure method; a reverse gravure method; a micro gravure method; roll coating methods such as a two-roll bead coating method and a bottom feed three-roll reverse coating method; a doctor knife method; a die coating method; a dipping coating method; a bar coating method; a combination thereof; and the like. Although the average thickness of the resin coating layer is not particularly limited, the average thickness of the resin coating layer is preferably 10 um or less, and more preferably 2 $\mu$m or less. Although the lower limit of the average thickness of the resin coating layer is not particularly limited, the average thickness of the resin coating layer is preferably 0.001 um or more for the purpose of attaining an effective gas barrier property.

The vapor-deposited film according to the embodiment of the present invention may further include a layer that contains a thermoplastic resin other than the polyvinyl alcohol polymer. Examples of the thermoplastic resin include: polyethylene; polyolefins such as polypropylene; polyesters such as polyethylene terephthalate; and the like, and the layer that contains a thermoplastic resin may be stretched. The layer that contains a thermoplastic resin may be provided on any of the substrate film, the metal vapor-deposited layer and the resin coating layer of the vapor-deposited film, directly, or via an adhesion layer.

As described in the foregoing, the vapor-deposited film according to the embodiment of the present invention enables the formation of a pinhole and/or a crack in a vapor deposition processing to be suppressed, and the deterioration of the gas barrier property thereof to be inhibited, and has both a superior thermal insulation property and a superior gas barrier property. Therefore, the vapor-deposited film according to the embodiment of the present invention can be preferably used as packaging materials or materials for vacuum thermal insulators.

EXAMPLES

Hereinafter, the present invention will be explained more specifically by way of Examples. However, the present invention is not in any way limited by Examples.

Production of Vapor-Deposited Film

Example 1

A synthetic silica manufactured by Fuji Silysia Chemical Ltd. ("Sylysia" 310P; the mean particle diameter as determined using a laser technique: 2.7 um) as an inorganic oxide and an ethylene-vinyl alcohol copolymer F101A (ethylene content: 32 mol%; degree of saponification: 99.9%) manufactured by Kuraray Co., Ltd. were dry-blended using a tumbler such that the amount of the synthetic silica with respect to 100 parts by mass of the ethylene-vinyl alcohol copolymer F101A was 0.03 parts by mass. Thereafter, the mixture was melted at 240 °C, and extruded from a die onto a casting roll concurrently with blowing an air toward the extrudate at 30 m/sec with an air knife to obtain an unstretched film having a thickness of 170 um. This film was brought into contact with hot water at 80 °C for 10 sec, stretched 3.2-fold along a machine direction and 3.0-fold along a transverse direction at 90 °C using a tenter type simultaneous biaxial stretching apparatus, and further heat-treated for 5 sec in a tenter conditioned at 170 °C to obtain a stretched heat-treated film having a thickness of 12 um and an entire width of 3.6 m. This film was slit over a width of 80 cm centering the middle point of the entire width of the film while rewinding the film, and a 4,000 m-long roll was obtained.

A piece for determination of volatile matter content was cut out from the central portion of the entire width of 80 cm of the roll and dried at 105 °C for 3 hours using a hot-air dryer, and the volatile matter content was determined from the mass before drying and the mass after drying according to the following equation:

$$\text{volatile matter content (\% by mass)} = [(\text{mass before drying} - \text{mass after drying})/\text{mass after drying}] \times 100$$

The volatile matter content in the substrate film used for vapor deposition according to Example 1 was 0.15% by mass. After the formation of the biaxially stretched film, the produced film was quickly packaged with an aluminum foil laminate film to prevent the film from absorbing moisture.

The film thus prepared was used as a substrate film, and aluminum was vapor-deposited on one side of the film using a batch-wise vapor deposition equipment EWA-105 manufactured by ULVAC, Inc. under conditions involving a surface temperature of the substrate film of 38 °C and a film travelling speed of 200 m/min to obtain a vapor-deposited film. The thickness of the vapor-deposited aluminum (i.e., the average thickness of the metal vapor-deposited layer) was 70 nm.

The mean particle size in the aluminum vapor-deposited layer was determined through a direct observation of the aluminum vapor-deposited layer from the front face side thereof using a SEM (scanning electron microscope). It is to be noted that the mean particle size as referred to in this Example means an average of particle sizes (n = 100) found in the SEM image (magnification: $\times$ 60,000; lower limit of measurement: 10 nm) shown in Fig. 1. SEM observation was performed on ZEISS ULTRA 55 manufactured by SII Nano Technology, Inc. A backscattered electron detector was used as a detector. The mean particle size in the aluminum vapor-deposited layer in Example 1 was 35 nm.

To 326.5 g of ion exchanged water was added 33.75 g of "EXCEVAL" RS-3110 (percentage content of ethylene: 6 mol%; degree of saponification: 98% or more) manufactured by Kuraray Co., Ltd., which was a polyethylene-vinyl alcohol copolymer obtained by saponification of a polyethylene-vinyl acetate polymer, as a material for a resin coating layer, and the mixture was stirred for 1 hour with heating at 90 °C to obtain an aqueous solution. After the aqueous solution was cooled to room temperature, 64.75 g of a 50% by mass aqueous isopropyl alcohol solution was added for the purpose of improving the stability of the solution. Further, to the solution was added 76 g of NHT-solB2 (an aqueous dispersion liquid of a synthetic hectorite; solid content concentration: 5% by mass; mean particle diameter: 3.8 um; standard deviation: 2.2 $\mu$m) manufactured by Topy Industries Ltd. to obtain 500 g of a resin composition containing the swelling inorganic layered silicate. The solid content concentration in the liquid was 7.5% by mass, and the percentage content of the swelling inorganic layered silicate in the solid content was 10% by mass. The resin composition was coated onto the aluminum vapor-deposited layer side of the vapor-deposited film obtained above, and dried using a hot-air dryer at 100 °C for 20 sec. The average thickness of the resin coating layer (i.e., the layer formed from the composition containing the ethylene-vinyl alcohol copolymer and the swelling inorganic layered silicate) after the drying was 1.5 $\mu$m.

Oxygen transmission rate (OTR) of the vapor-deposited film (coated film) including the resin coating layer thus obtained was evaluated. A part of the sample film was cut out, and the OTR thereof was determined in accordance with the method described in JIS K7126 (equal pressure method) using an oxygen transmission rate test system, model OX-TRAN 2/20 (detection limit: 0.01 mL/m$^2$·day·atm), manufactured by MOCON Inc. under conditions involving 90% RH on the resin coating layer side and 0% RH on the substrate film side of the coated film and a temperature of 40 °C. The oxygen transmission rate of the coated film according to Example 1 was 0.08 mL/m$^2$·day·atm. Herein, the oxygen transmission rate means a volume of an oxygen gas that transmits through a sample film per unit area (m$^2$), unit time of period (day) and unit pressure difference (atm) between two surfaces of the sample film.

An unstretched polypropylene film having a thickness of 50 $\mu$m (RXC-21 manufactured by Mitsui Chemicals Tohcello Inc.) and a stretched polyester film having a thickness of 15 um ("Lumirror" P60 manufactured by Toray Industries, Inc.) were provided on the coated film through dry lamination using an adhesive to obtain a multilayer film. The layer structure of the multilayer film involved stretched polyester film /coated film /unstretched polypropylene film, with the resin coating layer of the coated film being in contact with the stretched polyester film. "TAKELAC" A-385 /"TAKENATE" A-50 manufactured by Mitsui Chemicals, Inc. was used as an adhesive, with the amount of the adhesive applied being 4 g/m$^2$ in terms of solid content, and drying was carried out at 50 °C for 5 sec. In addition, aging was further carried out at 40 °C for 3 days after the drying.

The oxygen transmission rate of the multilayer film obtained above was evaluated. The oxygen transmission rate was 0.09 mL/m$^2$·day·atm. This indicated that the increase of the oxygen transmission rate caused by the lamination processing was 0.01 mL/m$^2$·day·atm.

Example 2

A multilayer film was obtained by the lamination according to the same layer structure as in Example 1 under the condition as described in Example 1 using the vapor-deposited film obtained in Example 1 before providing the resin coating layer. Under the same condition as Example 1, the oxygen transmission rate of the vapor-deposited film (OTR before the lamination) was determined to be 0.07 mL/m$^2$·day·atm and the oxygen transmission rate of the multilayer film (OTR after the lamination) was determined to be 0.11 mL/m$^2$·day·atm, indicating that the increase of the oxygen transmission rate caused by the lamination processing was 0.04 mL/m$^2$·day·atm.

Examples 3 to 5

Vapor-deposited films and multilayer films were obtained in a similar manner to Example 1 except that: the surface temperature of the substrate film in the vapor deposition was changed to 43 °C (Example 3), 48 °C (Example 4), and 53 °C (Example 5), respectively; and the resin coating layer was not provided, and these films were evaluated. The results are shown in Table 1. Favorable performance was confirmed on all evaluation items of these Examples.

Examples 6 to 8

Vapor-deposited films and multilayer films were obtained in a similar manner to Example 5 except that the volatile matter content in the substrate film before the vapor deposition was changed to 0.45% by mass (Example 6), 0.70% by mass (Example 7), and 0.95% by mass (Example 8), and these films were evaluated. The results are shown in Table 1. Favorable performance was confirmed on all evaluation items of these Examples.

Example 9

A vapor-deposited film and a multilayer film were obtained in a similar manner to Example 1 except that: the volatile matter content in the substrate film before the vapor deposition was changed to 1.05% by mass; the surface temperature of the substrate film in the vapor deposition was 38 °C; and the resin coating layer was not provided, and these films were evaluated. The results are shown in Table 1. Favorable performance was confirmed on all evaluation items.

Examples 10 to 12

Vapor-deposited film and multilayer films were obtained in a similar manner to Example 1 except that: the thickness of the vapor-deposited aluminum (i.e., the average thickness of the metal vapor-deposited layer) was changed to 95 nm (Example 10), 50 nm (Example 11), and 25 nm (Example 12); and the resin coating layer was not provided, and these films were evaluated. The results are shown in Table 1. Favorable performance was confirmed on all evaluation items of these Examples.

Example 13

A vapor-deposited film and a multilayer film were obtained in a similar manner to Example 9 except that: a substrate film before the vapor deposition was plasma-treated using a helium gas as a discharge gas under a power of 700 W, a Watt density of 212 W·min/m$^2$ and a line speed of 100 m/min; and the surface temperature of the substrate film in the vapor deposition was changed to 53 °C, and these films were evaluated. The results are shown in Table 1. Favorable performance was confirmed on all evaluation items.

Example 14

A vapor-deposited film and a multilayer film were obtained in a similar manner to Example 13 except that: the synthetic silica was not added before the melting of EVOH in the production of the substrate film; and the surface temperature of the substrate film in the vapor deposition was changed to 38 °C, and these films were evaluated. The results are shown in Table 1. Favorable performance was confirmed on all evaluation items.

Comparative Example 1

A vapor-deposited film and a multilayer film were obtained in a similar manner to Example 1 except that: the synthetic silica was not added before the melting of EVOH in the production of the substrate film; the volatile matter content in the substrate film before the vapor deposition was changed to 1.15% by mass; and the resin coating layer was not provided, and these films were evaluated. The mean particle size in the metal vapor-deposited layer of the vapor-deposited film thus obtained was 155 nm, the oxygen transmission rate of the vapor-deposited film was 0.16 mL/m$^2$·day·atm, and the oxygen transmission rate of the multilayer film was 0.28 mL/m$^2$·day·atm. Thus, deterioration of the gas barrier property was found, and the performances were proved to be insufficient.

Comparative Example 2

A vapor-deposited film and a multilayer film were obtained in a similar manner to Example 1 except that: the synthetic silica was not added before the melting of EVOH in the production of the substrate film; the volatile matter content in the substrate film before the vapor deposition was 0.15% by mass; and the resin coating layer was not provided, and these films were evaluated. Deterioration of the gas barrier property was found, and the performances were proved to be insufficient.

Comparative Example 3

A vapor-deposited film and a multilayer film were obtained in a similar manner to Example 2 except that the surface temperature of the substrate film in the vapor deposition was changed to 62 °C, and these films were evaluated. Deterioration of the gas barrier property after the lamination as compared with that before the lamination (i.e., deterioration of OTR) was significant, and the performances were proved to be insufficient.

Comparative Example 4

A vapor-deposited film and a multilayer film were obtained in a similar manner to Example 13 except that: the surface temperature of the substrate film in the vapor deposition was changed to 62 °C; and the volatile matter content in the substrate film before the vapor deposition was 0.15% by mass, and these films were evaluated. Deterioration of the gas barrier property after the lamination as compared with that before the lamination (i.e., deterioration of OTR) was significant, and the performances were proved to be insufficient.

In Table 1, "∘" in the columns of "inorganic oxide", "plasma treatment" and "resin coating layer" indicates that the inorganic oxide was used, the plasma treatment was conducted and the resin coating layer was provided, respectively, and "×" in the columns of "inorganic oxide", "plasma treatment" and "resin coating layer" indicates that the inorganic oxide was not used, the plasma treatment was not conducted and the resin coating layer was not provided, respectively. The "inorganic oxide" used was an identical "synthetic silica" to that used in Example 1.

Table 1

| | Inorganic oxide | Volatile matter content in substrate film used for vapor deposition | Surface temperature of substrate film in vapor deposition | Plasma treatment | Resin coating layer | Average thickness of metal vapor-deposited layer | Mean particle size in metal vapor-deposited layer | OTR before lamination | OTR after lamination | Difference of OTR |
|---|---|---|---|---|---|---|---|---|---|---|
| | ○/× | % by mass | °C | ○/× | ○/× | nm | nm | mL/m²·day·atm | mL/m²·day·atm | OTR before - OTR after |
| Example 1 | ○ | 0.15 | 38 | × | ○ | 70 | 35 | 0.08 | 0.09 | 0.01 |
| Example 2 | ○ | 0.15 | 38 | × | × | 70 | 35 | 0.07 | 0.11 | 0.04 |
| Example 3 | ○ | 0.15 | 43 | × | × | 70 | 64 | 0.09 | 0.12 | 0.03 |
| Example 4 | ○ | 0.15 | 48 | × | × | 70 | 74 | 0.09 | 0.13 | 0.04 |
| Example 5 | ○ | 0.15 | 53 | × | × | 70 | 95 | 0.10 | 0.15 | 0.05 |
| Example 6 | ○ | 0.45 | 53 | × | × | 70 | 118 | 0.13 | 0.18 | 0.05 |
| Example 7 | ○ | 0.70 | 53 | × | × | 70 | 123 | 0.15 | 0.20 | 0.05 |
| Example 8 | ○ | 0.95 | 53 | × | × | 70 | 142 | 0.15 | 0.23 | 0.08 |
| Example 9 | ○ | 1.05 | 38 | × | × | 70 | 92 | 0.11 | 0.18 | 0.07 |
| Example 10 | ○ | 0.15 | 38 | × | × | 95 | 42 | 0.05 | 0.07 | 0.02 |
| Example 11 | ○ | 0.15 | 38 | × | × | 50 | 55 | 0.60 | 0.65 | 0.05 |
| Example 12 | ○ | 0.15 | 38 | × | × | 25 | 72 | 1.21 | 1.30 | 0.09 |
| Example 13 | ○ | 1.05 | 53 | ○ | × | 70 | 102 | 0.11 | 0.15 | 0.04 |
| Example 14 | × | 1.05 | 38 | ○ | × | 70 | 143 | 0.16 | 0.25 | 0.09 |
| Comparative Example 1 | × | 1.15 | 53 | × | × | 70 | 155 | 0.16 | 0.28 | 0.12 |
| Comparative Example 2 | × | 0.15 | 53 | × | × | 70 | 152 | 0.06 | 0.17 | 0.11 |
| Comparative Example 3 | ○ | 0.15 | 62 | × | × | 70 | 163 | 0.18 | 0.32 | 0.14 |

| | Inorganic oxide | Volatile matter content in substrate film used for vapor deposition | Surface temperature of substrate film in vapor deposition | Plasma treatment | Resin coating layer | Average thickness of metal vapor-deposited layer | Mean particle size in metal vapor-deposited layer | OTR before lamination | OTR after lamination | Difference of OTR |
|---|---|---|---|---|---|---|---|---|---|---|
| | ○/× | % by mass | °C | ○/× | ○/× | nm | nm | mL/m$^2$·day·atm | mL/m$^2$·day·atm | OTR before - OTR after |
| Comparative Example 4 | ○ | 0.15 | 62 | ○ | × | 70 | 153 | 0.16 | 0.28 | 0.12 |

As indicated by the results shown in Table 1, in the vapor-deposited films according to Examples, the mean particle size in the metal vapor-deposited layer as determined using an electron microscope was 150 nm or less, and the formation of a pinhole and/or a crack was suppressed both before and after the lamination processing, resulting in inhibition of the deterioration of the gas barrier property of the films. On the other hand, in the vapor-deposited films according to Comparative Examples, the mean particle size was greater than 150 nm, a pinhole and/or a crack was formed before and/or after the lamination processing, and the gas barrier property of the films was deteriorated.

[INDUSTRIAL APPLICABILITY]

According to the vapor-deposited film of the present invention, formation of a pinhole and/or a crack can be suppressed in a processing of a vapor-deposited film such as lamination, and deterioration of the gas barrier property thereof can be inhibited. Therefore, the vapor-deposited film can be preferably used as packaging materials and materials for vacuum thermal insulators.

**Claims**

1. A vapor-deposited film comprising:

   a substrate film that comprises a polyvinyl alcohol polymer; and
   a metal vapor-deposited layer provided on the substrate film,
   a mean particle size in the metal vapor-deposited layer as determined using an electron microscope being 150 nm or less,
   wherein:

   the mean particle size in the metal vapor-deposited layer means a number-average of the maximum length along a single direction of the respective metal particles found using an electron microscope, and
   a degree of saponification of the polyvinyl alcohol polymer is 99 mol% or more.

2. The vapor-deposited film according to claim 1, wherein an average thickness of the metal vapor-deposited layer is 30 nm or more and 100 nm or less.

3. The vapor-deposited film according to claim 1, wherein the substrate film further comprises an inorganic oxide.

4. The vapor-deposited film according to claim 1, wherein the substrate film optionally further comprises an inorganic oxide,
   with the proviso that in case the substrate film comprises the inorganic oxide, the percentage content of the inorganic oxide in the substrate film with respect to 100% by mass of the polyvinyl alcohol polymer is 1% by mass or less.

5. The vapor-deposited film according to claim 1, further comprising a resin coating layer that contains a polyvinyl alcohol polymer and that is provided on the metal vapor-deposited layer.

6. The vapor-deposited film according to claim 1, further comprising a layer that comprises a thermoplastic resin other than the polyvinyl alcohol polymer.

7. A packaging material comprising the vapor-deposited film according to claim 1.

8. A vacuum thermal insulator comprising the vapor-deposited film according to claim 1.

9. A method for producing the vapor-deposited film according to claim 1, wherein:

   a volatile matter content in the substrate film used for vapor deposition is 1.1% by mass or less; and
   a surface temperature of the substrate film in vapor deposition is 60 °C or less.

10. The method for producing the vapor-deposited film according to claim 9, comprising:
    plasma-treating a surface of the substrate film before vapor deposition.

**Patentansprüche**

1. Dampfbeschichteter Film, umfassend:

   einen Substratfilm, der ein Polyvinylalkohol-Polymer umfasst; und
   eine dampfbeschichtete Metallschicht, die auf dem Substratfilm bereitgestellt ist,
   wobei eine mittlere Teilchengröße in der dampfbeschichteten Metallschicht, gemäß einer Bestimmung mittels eines Elektronenmikroskops, 150 nm oder weniger beträgt, wobei:

   die mittlere Teilchengröße in der dampfbeschichteten Metallschicht einen zahlenmäßigen Durchschnitt der maximalen Länge entlang einer einzigen Richtung der jeweiligen Metallpartikel bedeutet, die mittels eines Elektronenmikroskops gefunden werden, und
   ein Verseifungsgrad des Polyvinylalkohol-Polymers 99 Mol% oder mehr beträgt.

2. Dampfbeschichteter Film nach Anspruch 1, wobei eine durchschnittliche Dicke der dampfbeschichteten Metallschicht 30 nm oder mehr und 100 nm oder weniger beträgt.

3. Dampfbeschichteter Film nach Anspruch 1, wobei der Substratfilm weiter ein anorganisches Oxid umfasst.

4. Dampfbeschichteter Film nach Anspruch 1, wobei der Substratfilm gegebenenfalls weiter ein anorganisches Oxid umfasst, mit der Maßgabe, dass im Fall, dass der Substratfilm das anorganische Oxid umfasst, der prozentuale Gehalt des anorganischen Oxids im Substratfilm, bezogen auf 100 Massen-% des Polyvinylalkohol-Polymers, 1 Massen-% oder weniger beträgt.

5. Dampfbeschichteter Film nach Anspruch 1, weiter eine Harzbeschichtungsschicht umfassend, die ein Polyvinylalkohol-Polymer enthält und die auf der dampfbeschichteten Metallschicht bereitgestellt ist.

6. Dampfbeschichteter Film nach Anspruch 1, weiter umfassend eine Schicht, die ein von dem Polyvinylalkohol-Polymer verschiedenes thermoplastisches enthält.

7. Verpackungsmaterial, umfassend den dampfbeschichteten Film nach Anspruch 1.

8. Vakuum-Wärmedämmstoff, umfassend den dampfbeschichteten Film nach Anspruch 1.

9. Verfahren zur Herstellung des dampfbeschichteten Films nach Anspruch 1, wobei:

   ein flüchtiger Substanzengehalt im Substratfilm, der zur Dampfbeschichtung verwendet wird, 1,1 Massen-% oder weniger beträgt; und
   eine Oberflächentemperatur des Substratfilms bei der Dampfbeschichtung 60 °C oder weniger beträgt.

10. Verfahren zur Herstellung des dampfbeschichteten Films nach Anspruch 9, umfassend:
    Plasma-Behandeln einer Oberfläche des Substratfilms vor der Dampfbeschichtung.


**Revendications**

1. Film déposé par évaporation sous vide comprenant :

   un film de substrat qui comprend un polymère d'alcool polyvinylique ; et
   une couche métallique déposée par évaporation sous vide prévue sur le film de substrat,
   une taille particulaire moyenne dans la couche métallique déposée par évaporation sous vide telle que déterminée en utilisant un microscope électronique étant de 150 nm ou moins,
   dans lequel :

   la taille particulaire moyenne dans la couche métallique déposée par évaporation sous vide signifie une moyenne en nombre de la longueur maximale le long d'une direction unique des particules métalliques respectives trouvée en utilisant un microscope électronique, et
   un degré de saponification du polymère d'alcool polyvinylique est de 99 % en mole ou plus.

**2.** Film déposé par évaporation sous vide selon la revendication 1, dans lequel une épaisseur moyenne de la couche métallique déposée par évaporation sous vide est de 30 nm ou plus et 100 nm ou moins.

**3.** Film déposé par évaporation sous vide selon la revendication 1, dans lequel le film de substrat comprend en outre un oxyde inorganique.

**4.** Film déposé par évaporation sous vide selon la revendication 1, dans lequel le film de substrat comprend en option en outre un oxyde inorganique,
à condition qu'au cas où le film de substrat comprenne l'oxyde inorganique, la teneur en pourcentage de l'oxyde inorganique dans le film de substrat par rapport à 100 % en masse du polymère d'alcool polyvinylique est de 1 % en masse ou moins.

**5.** Film déposé par évaporation sous vide selon la revendication 1, comprenant en outre une couche d'enrobage de résine qui contient un polymère d'alcool polyvinylique et qui est prévue sur la couche métallique déposée par évaporation sous vide.

**6.** Film déposé par évaporation sous vide selon la revendication 1, comprenant en outre une couche qui comprend une résine thermoplastique autre que le polymère d'alcool polyvinylique.

**7.** Matériau d'emballage comprenant le film déposé par évaporation sous vide selon la revendication 1.

**8.** Isolant thermique sous vide comprenant le film déposé par évaporation sous vide selon la revendication 1.

**9.** Procédé de production du film déposé par évaporation sous vide selon la revendication 1, dans lequel :

une teneur en matière volatile dans le film de substrat utilisé pour le dépôt par évaporation sous vide est de 1,1 % en masse ou moins ; et
une température superficielle du film de substrat dans le dépôt par évaporation sous vide est de 60 °C ou moins.

**10.** Procédé de production du film déposé par évaporation sous vide selon la revendication 9, comprenant :
traiter au plasma une surface du film de substrat avant dépôt par évaporation sous vide.

200 nm | EHT = 3.00 kV | Signal A = AsB | Aperture No = 6 | Scan Speed = 9 | Date :30 Jan 2012
WD = 3.0 mm | Mag = 60.00 K X | High Current = On | Contrast = 74.6 % | Time :12:46:12
ESB Grid = 1441 V | Brightness = 46.1 %

Fig. 1

**EP 2 818 316 B1**

**REFERENCES CITED IN THE DESCRIPTION**

**Patent documents cited in the description**

- JP 2002310385 A
- JP 2005290108 A